Europäisches Patentamt

European Patent Office

Office européen des brevets

(11) Publication number: **0 209 925**
**A1**

# EUROPEAN PATENT APPLICATION

(21) Application number: 86201029.5

(22) Date of filing: 16.06.86

(51) Int. Cl.⁴: **C23C 14/06** , C23C 14/32

(30) Priority: 17.06.85 US 745735

(43) Date of publication of application:
28.01.87 Bulletin 87/05

(84) Designated Contracting States:
DE FR GB NL

(71) Applicant: N.V. Philips' Gloeilampenfabrieken
Groenewoudseweg 1
NL-5621 BA Eindhoven(NL)

(72) Inventor: Sweet, Richard Clark
c/o INT. OCTROOIBUREAU B.V. Prof.
Holstlaan 6
NL-5656 AA Eindhoven(NL)

(74) Representative: Auwerda, Cornelis Petrus et
al
INTERNATIONAAL OCTROOIBUREAU B.V.
Prof. Holstlaan 6
NL-5656 AA Eindhoven(NL)

(54) Method of improving wear resistance of titanium bodies.

(57) Wear resistance of surfaces of titanium and titanium alloy bodies that are in contact with each other during movement of the bodies relative to each other is improved by ion plating a thin layer of titanium nitride on the surfaces of these bodies.

EP 0 209 925 A1

## Method of improving wear resistance of titanium bodies.

### ORIGIN OF THE INVENTION

The invention described herein was made under contract with the United States Government and may be manufactured and used by or for the Government for governmental purposes without the payment of any royalties thereon or thereunder.

### BACKGROUND OF THE INVENTION

This invention relates to a method of improving the wear resistance of mutually contacting titanium and titanium alloy bodies, one moving relative to another.

Bodies formed of titanium and its alloys wear very poorly when run against each other particularly when run in a dry, non-lubricated condition, a condition which frequently occurs when such bodies are employed as mutually opposing components of cryocoolers.

In addition, mutually contacting titanium and titanium alloy components when moving relative to each other exhibit a marked tendency to destructive galling and seizing.

Mutual contacting of titanium and titanium alloy cryocooler components, one moving relative to another, occurs, for example, when the cryocooler is employed in a launched vehicle. Thus, under some conditions titanium piston rods that are ordinarily magnetically suspended in titanium cyclinders are forced into contact with the shaft. Additionally, undesired mutual contact of opposing titanium components, one moving relative to another may also occur due to power failure and vibration of the cryocooler.

Titanium and titanium alloy components are also frequently employed in the chemical, aeronautical and naval industries and here too the problems of wear, galling and seizing also frequently occur when these components are in mutual contact and in motion relative to each other.

A method of providing a protective coating on titanium and titanium alloys is shown in Zaplatynsky, U.S. Patent 4,434,189. This patent shows a method of creating a protective coating of titanium nitride on titanium and titanium alloy substrates by heating (for example with a laser) a portion of a surface of a moving substrate below its melting point, but sufficiently high to cause a reaction with nitrogen, while in a nitrogen atmosphere. By this means the heated portion of the surface is converted to a protective layer of titanium nitride.

This method as the disadvantage of requiring the use of high heat, which at the patent shows in col.3, lines 1-6, may be as high as 1800°C. The use of such high temperatures is frequently undesirable as it causes damage to thin, accurately dimensioned surfaces and structures.

Further the formation of a titanium nitride surface by ion plating on steel objects is shown in Sasanuma, U.S. Patent 4,480,010. However, there is no suggestion in this patent of forming the titanium nitride coating on a titanium body nor is there any suggestion that such a coating would improve the behavior of mutually contacting titanium bodies.

Itaba et al, U. S. Patent 4,450,205 discloses a method of preventing separation of a titanium coating from a metal substrate in a blade member and preventing stress or cracking of the tungsten layer by forming a thin layer of titanium nitride (of a thickness of 0.5-10 $\mu$m) on the tungsten surface by ion plating. However, this patent teaches nothing about the use of ion plated titanium nitride coatings for improving the behavior of mutually contacting titanium and titanium alloy bodies moving relative to each other.

### BRIEF SUMMARY OF THE INVENTION

A principal object of this invention is to provide an improved method for improving the wear resistance of mutually contacting titanium and titanium alloy bodies at least one moving relative to another.

This and other objects of the invention will be apparent from the description of the invention that follows.

According to the method of the invention the wear resistance of the surfaces of mutually contacting bodies titanium and titanium alloy bodies, at least one moving relative to another is improved by forming, by ion plating, a thin layer of titanium nitride or the surfaces of the bodies. Preferably, the thickness of the titanium layer is 2-4 $\mu$m as this thickness provides the optimum wear resistance.

Mutually contacting surfaces of mutually moving titanium and titanium alloy bodies have been found to exhibit essentially no wear when protected by a titanium nitride layer provided by the method of the invention. Further, the coating provided by this method also prevents galling and seizing of the surfaces of such mutually contacting titanium and titanium alloy bodies.

Additionally, the method of the invention has the advantage over that of the Zaplatynsky patent of not requiring the use of high heat and thus not damaging thin, accurately dimensioned surfaces and structures.

## DETAILED DESCRIPTION OF THE INVENTION

For a more complete understanding the invention will now be described in greater detail.

### Example

Titanium bearings adapted for use in Stirling cycle cryocoolers were degreased and cleaned using a vapor degreaser equipped with a spray wand to dislodge any of the inherent contamination and remove soil from the surfaces.

The components were then placed in an ion deposition chamber provided with a titanium cathode. The pressure in the chamber was reduced to $10^{-6}$ Torr first by vacuum pumping for ten minutes and then by cryo pumping. Then argon was admitted to this chamber until a pressure of $6 \times 10^{-2}$ Torr was achieved. The surfaces of the titanium bearings were then plasma etched in the argon atmosphere at 350°C employing 1 amp at 350V for a period of 15 minutes. The titanium cathode was then activated in this argon atmosphere by employing 75 V, 7 amps atmospheres for four minutes. The argon was then replaced by nitrogen and two depositions of TiN of eight minutes each were carried out employing the same current voltage conditions.

The current flow was then interrupted, the nitrogen atmosphere was replaced by a vacuum and the coated bearings were cooled for 30 minutes and then nitrogen was admitted to speed up the cooling. The coated bearings were then removed. Analysis showed a uniform coating of titanium nitrid of a thickness of approximately 1.8-2.0μm to be present on the bearings.

An evaluation of the effectiveness of the titanium nitride coating on a titanium surface was made. A cylindrical rod and cylinder were prepared so that an accurately dimensioned fit of rod into cylinder was established. The ground rod and honed cylinder were prepared with a fine surface finish, typically an 8-16 microinch finish.

The fit between the cylinder and rod surfaces was established at 0.0007 +/- 0.0001 inches. The surfaces were cleaned and coated with a titanium nitride layer as described previously and placed in a fixture whereby the rod and cylinder surfaces could be brought into contact with known preloading on the contact surfaces. The fixture was mounted to a shaker table so that the rod-cylinder sample could be vibrated with known energies and also by repositioning the fixture the shaking could be performed in each of the three aces of motion. Typically a 3-5 g preload force was imposed during a 100-500 Hz white noise vibration was imposed on the sample causing the rod to move in a reciprocal sliding motion in the cylinder. Tests were run for 5 minutes duration.

The coated surfaces of rod and cylinder were examined after each run for evidence of contact, wear and particulate generation. No evidence of wear or particulate generation was found for the conditions set forth. A slight burnishing or polishing of some areas was noted in some instances.

## Claims

1. A method of preventing wear to the surface of titanium bodies or titanium alloy bodies subject to mutual contact while at least one of said bodies is moving relative to another of said bodies, said method comprising forming, by ion plating, a thin layer of titanium nitride on said surfaces.

2. The method of Claim 1 where the thickness of the titanium nitride layer is about 2-4 μm.

3. Mutually contacting titanium or titanium alloy bodies the contacting surfaces of which are coated with a thin layer of titanium nitride formed by ion plating.

# EUROPEAN SEARCH REPORT

**European Patent Office**

Application number

EP 86 20 1029

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | DE-A-2 431 448 (AIRCO)<br>* Claims 1-4,9,10; page 3, lines 31,32; page 4, lines 1,2 * | 1 | C 23 C 14/06<br>C 23 C 14/32 |
| Y | PATENTS ABSTRACTS OF JAPAN, vol. 6, no. 131 (C-114)[1009], 17th July 1982; & JP-A-57 57 868 (MASAMITSU TAKEBAYASHI) 07-04-1982<br>* Abstract * | 1,2 | |
| Y | THIN SOLID FILMS, vol. 45, 1977, pages 583-589, Elsevier Sequoia SA, Lausanne, CH, printed in the Netherlands; D.G. TEER et al.: "The formation of low friction wear-resistant surfaces on titanium by ion plating"<br>* Page 583, abstract * | 1,2 | |
| A | CHEMICAL ABSTRACTS, vol. 89, 1978, page 242, abstract no. 10109u, Columbus, Ohio, US; & JP-A-77 111 891 (HONDA MOTOR CO. LTD.) 19-09-1977 | 1,3 | **TECHNICAL FIELDS SEARCHED (Int. Cl.4)**<br><br>C 23 C |
| A | DE-A-2 145 254 (W.C. HERAEUS)<br>* Claims 1,3 * | 1 | |
| | --- -/- | | |

The present search report has been drawn up for all claims

| Place of search | Date of completion of the search | Examiner |
|---|---|---|
| THE HAGUE | 29-10-1986 | ELSEN D.B.A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO Form 1503 03 82

## DOCUMENTS CONSIDERED TO BE RELEVANT

Page 2

| Category | Citation of document with indication, where appropriate, of relevant passages | Relevant to claim | CLASSIFICATION OF THE APPLICATION (Int. Cl.4) |
|---|---|---|---|
| A | FR-A-1 118 086 (METALLGESELLSCHAFT AG) * Claims; page 1, left-hand column * | 1 | |
| A | THIN SOLID FILMS, vol. 73, 1980, pages 267-274, Elsevier Sequoia SA, Lausanne, CH, printed in the Netherlands; S. RAMALINGAM et al.: "Reactively sputtered TiN coatings for tribological applications" * Page 267, abstract * | 1,3 | |
| A | THIN SOLID FILMS, vol. 54, no. 1, October 1978, pages 67-74, Elsevier Sequoia SA, Lausanne, CH, printed in the Netherlands; M. KOBAYASHI et al.: "TiN and TiC coating on cemented carbides by ion plating" * Page 67, abstract * | 1,3 | TECHNICAL FIELDS SEARCHED (Int. Cl.4) |
| A | US-A-3 787 223 (C.D. REEDY) | | |
| | ---                    -/- | | |

The present search report has been drawn up for all claims

| Place of search | Date of completion of the search | Examiner |
|---|---|---|
| THE HAGUE | 29-10-1986 | ELSEN D.B.A. |

## DOCUMENTS CONSIDERED TO BE RELEVANT

Page 3

| Category | Citation of document with indication, where appropriate, of relevant passages | Relevant to claim | CLASSIFICATION OF THE APPLICATION (Int. Cl.4) |
|---|---|---|---|
| X,P | CHEMICAL ABSTRACTS, vol. 104, no. 18, 5th May 1986, page 305, abstract no. 153824n, Columbus, Ohio, US; R.A. ROWNTREE: "Surface-treated titanium alloy gears for space mechanisms", & EUR. SPACE AGENCY, [SPEC. PUBL.] ESA SP 1985, ESA SP-231, Eur. Space Mech. Tribol. Symp., 2nd, 167-71 | 1 | |
| | --- | | |
| X,P | CHEMICAL ABSTRACTS, vol. 103, no. 18, 4th November 1985, page 242, abstract no. 145785q, Columbus, Ohio, US; K.B. KATSOV et al.: "Effect of a titanium nitride coating on low-cycle fatigue of titanium alloys VT1-0 and AT3 in a corrosive medium", & FIZ.-KHIM. MEKH. MATER. 1985, 21(3), 102-3 * Abstract * | 1,2 | |
| | ----- | | TECHNICAL FIELDS SEARCHED (Int. Cl.4) |

The present search report has been drawn up for all claims

| Place of search | Date of completion of the search | Examiner |
|---|---|---|
| THE HAGUE | 29-10-1986 | ELSEN D.B.A. |